# FASCICULE DE BREVET EUROPEEN

(11) **EP 4 119 967 B1**
(45) Date de publication et mention de la délivrance du brevet: **04.03.2026**
(21) Numéro de dépôt: 22184533.2
(22) Date de dépôt: 12.07.2022
(51) Int. Cl.: G01R 31/62, G01R 31/27

(54) **ETAGE DE PUISSANCE COMPRENANT UN DISPOSITIF DE COMMANDE**
LEISTUNGSSTUFE UMFASSEND EINE STEUERUNGSEINHEIT
POWER STAGE COMPRISING A CONTROL UNIT

(30) Priorité: 13.07.2021 FR 2107579
(43) Date de publication de la demande: 18.01.2023
(73) Titulaire: Safran Electrical & Power, 31700 Blagnac (FR)
(72) Inventeur: ABDESSELAM, Francis, 78400 Chatou (FR)
(74) Mandataire: Atout PI Laplace

(56) Documents cités:
- EP-A1- 2 961 067
- EP-A1- 3 621 192
- FR-A1- 3 077 912
- US-A- 4 685 020
- US-A- 5 900 683
- US-A1- 2020 169 179

## Description

Le domaine de l'invention est celui des commandes de module d'électronique de puissance permettant de piloter le fonctionnement de composants électroniques de puissance. De manière connue, les modules de puissance représentent des composants électroniques traitant de fortes puissances et présentent, de ce fait, une attention particulière dans leur conception et leur suivi en cours de vie et d'utilisation.

Les documents US 5 900 683 A, US 2020/169179 A1, EP 2 961 067 A1, EP 3 621 192 A1, US 4 685 020 A et FR 3 077 912 A1 décrivent diverses commandes de modules d'électroniques de puissances.

Ainsi, une commande de module de puissance est généralement utilisée de sorte à pouvoir exercer une influence sur le module de puissance en cas de dysfonctionnement ou de défaillance du module, de fonctionnement inhabituel ou encore de manière à permettre de viser un fonctionnement précis du module de puissance. Néanmoins, il est nécessaire, aujourd'hui, de pouvoir isoler cette commande par rapport au module de puissance de sorte à pouvoir protéger la commande de tout dysfonctionnement du module de puissance.

Plus précisément, certains domaines comme l'aéronautique imposent des normes de respect pour les composants électroniques. Ainsi, à titre indicatif, la norme D0-254 fixe les conditions de sécurité applicables aux composants électroniques critiques de l'avionique dans l'aviation commerciale et l'aviation générale. Cette norme précise notamment les contraintes de développement liées à l'obtention de la certification d'un composant électronique d'avionique. Ainsi, il est aujourd'hui requis, pour un module de puissance quelconque utilisé en aéronautique, d'être commandé par l'intermédiaire d'un moyen de commande isolé du module.

Habituellement, la fonction de commande isolée du module de puissance est réalisée selon les principes suivants :
- Une commande isolée par optocoupleur. Un optocoupleur ou autrement nommé photocoupleur, est un composant électronique capable de transmettre un signal d'un circuit électrique à un autre, sans qu'il y ait de contact galvanique entre eux. L'optocoupleur présente ainsi l'avantage de permettre une isolation entre la commande et le module de puissance de manière à protéger la commande. Néanmoins, l'utilisation d'une commande basée sur l'optocoupleur est, actuellement, un composant jugé comme peu fiable et interdit dans certains domaines d'exploitation comme le domaine de l'aéronautique par exemple. En effet, une commande basée sur l'utilisation de l'optocoupleur peut ne pas transmettre l'intégralité d'un signal optique par exemple et présenter des pertes induisant la perte d'information parfois essentielle. De plus, l'utilisation de ce type de technologie induit à l'utilisation de composant électronique à relative faible durée de vie pour des besoins dans le domaine de l'aéronautique civile pouvant dépasser 250.000 heures d'utilisation pour un composant électronique quelconque.

- Une commande isolée par un transformateur d'impulsion à circuit magnétique. Le transformateur d'impulsion présente l'avantage, par rapport à l'optocoupleur, de pouvoir fonctionner à une fréquence élevée, d'être très simple dans le montage et d'avoir la possibilité de fournir un courant important. Néanmoins, un transformateur d'impulsion à circuit magnétique ne permet de fonctionner que de manière alternative et seulement pour des commandes courtes. Ainsi, une commande isolée utilisant un transformateur d'impulsion à circuit magnétique ne permet pas la transmission de commandes continues.
- Une commande isolée par un transformateur sans circuit magnétique. Néanmoins, comme pour les transformateurs d'impulsion à circuit magnétique, il n'est possible de fonctionner qu'avec des impulsions courtes.
- Une commande isolée par un transformateur piézo-électrique. En effet, la déformation d'un certain type de matériau permet la génération d'une tension électrique. Dès lors, il peut être envisagé de déformer de manière définie le matériau afin de générer la bonne tension pour influencer le module de puissance. Néanmoins, la puissance fournie reste relativement faible en comparaison des autres transformateurs pour une structure nécessitant l'utilisation de composants complexes et couteux.
- Enfin, une commande basée sur une isolation capacitive présente, aujourd'hui, des capacités d'isolation très intéressante. Néanmoins, ce type de technologie comprend des composants complexes et nécessite donc une certification relativement importante en comparaison des composants des autres types de commande.

En outre, la majorité des technologies d'isolation présentées précédemment fonctionnent de manière unidirectionnelle. En effet, la commande du module de puissance permet le contrôle du module en donnant des instructions en direction du module. Ainsi, afin d'obtenir une bidirectionnalité de la communication entre un module de puissance et sa commande, il devient nécessaire d'ajouter des composants à la commande, augmentant ainsi le coût global de cette dernière et impactant la compacité de la commande.

L'invention vise à pallier tout ou partie des problèmes cités plus haut en proposant une commande simple de module de puissance, isolée du module commandé et permettant de fonctionner de manière bidirectionnelle, c'est-à-dire en induisant un contrôle du module et en recevant des informations liées au fonctionnement du module de puissance.

A cet effet, l'invention a pour objet un étage de puissance selon les revendications.

L'invention sera mieux comprise et d'autres avantages apparaîtront à la lecture de la description détaillée d'un mode de réalisation donné à titre d'exemple, description illustrée par le dessin joint dans lequel :
[Fig.1] la figure 1 représente un dispositif de commande d'un étage de puissance isolé et bidirectionnelle selon l'invention ;
[Fig.2] la figure 2 représente une architecture de pont complet selon l'invention ;
[Fig.3] la figure 3 est un chronogramme représentant la combinaison du signal commande et de l'onde impulsive et de la conséquence sur le pont complet selon l'invention ;

Par souci de clarté, les mêmes éléments porteront les mêmes repères dans les différentes figures.

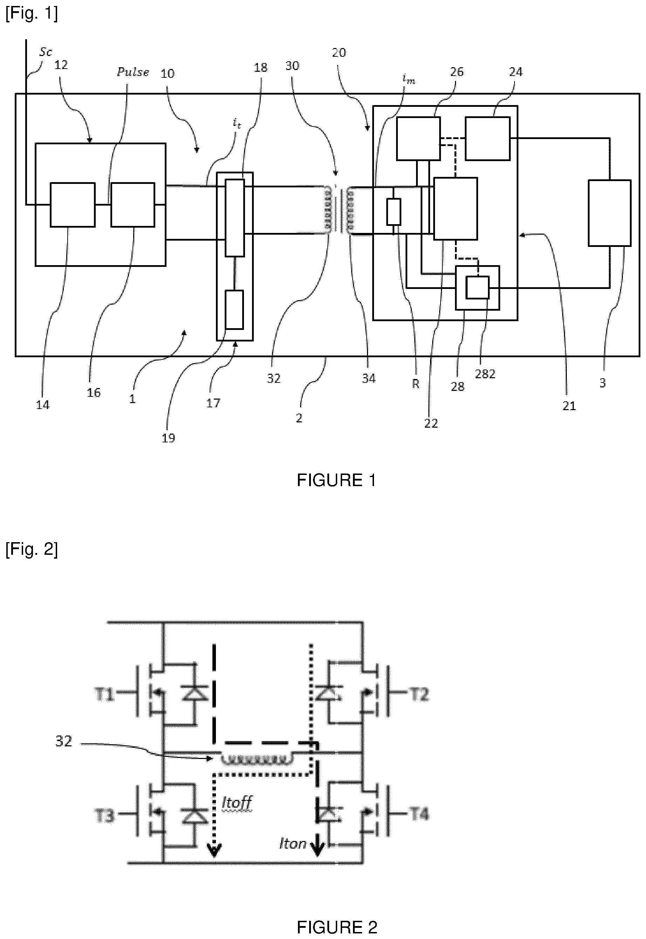

La figure 1 représente un étage de puissance 2 comprenant un dispositif de commande 1 et un transistor de puissance 3 connecté au dispositif de commande 1 afin d'être piloté par le dispositif de commande 1.

Le dispositif de commande 1 comprend un circuit primaire 10 et un circuit secondaire 20. Le circuit primaire 10 comprend :
- un module de commande 12 apte à générer un courant de commande it,
- un détecteur de dysfonctionnement du circuit primaire 17 apte à détecter un dysfonctionnement du circuit primaire 10, c'est-à-dire un fonctionnement non nominal du circuit primaire 10.

Le dispositif de commande 1 comprend également un transformateur 30 d'impulsion comprenant un enroulement primaire 32 relié au circuit primaire 10 et un enroulement secondaire 34, relié au circuit secondaire 20, magnétiquement couplé à l'enroulement primaire 32 et apte à générer, à partir du courant de commande *iₜ*, un courant impulsionnel induit *iₘ* en direction du circuit secondaire 20. Le courant impulsionnel induit *iₘ* permet le pilotage du transistor de puissance 3. En effet, l'enroulement primaire 32, traversé par le courant de commande *iₜ*, permet la création d'un champ électromagnétique entre le premier enroulement 32 et le deuxième enroulement 34 et d'une induction magnétique au niveau du deuxième enroulement 34 de sorte à générer le courant impulsionnel induit *iₘ*, qui est un courant comprenant des impulsions représentatives des impulsions observables dans le courant de commande *iₜ*.

Le circuit secondaire 20, qui est relié au transistor de puissance 3 comprend une commande de puissance et de détection de défaut 21, relié, d'une part, à l'enroulement secondaire 34 du transformateur 30 d'impulsion et, d'autre part, au transistor de puissance 3, apte à détecter un dysfonctionnement du circuit secondaire 20 et/ou du transistor de puissance 3, c'est-à-dire un fonctionnement non nominal du circuit secondaire 20 et/ou un fonctionnement non nominal du transistor de puissance 3.

La commande de puissance et de détection de défaut 21 est apte à communiquer le dysfonctionnement du circuit secondaire 20 au détecteur de dysfonctionnement du circuit primaire 17. De la même manière, la commande de puissance et de détection de défaut 21 est apte à communiquer le dysfonctionnement du transistor de puissance 3 au détecteur de dysfonctionnement du circuit primaire 17.

La communication entre la commande de puissance et de détection de défaut 21 et le détecteur de dysfonctionnement du circuit primaire 17 présente l'avantage permettre un fonctionnement bidirectionnel de la commande entre le dispositif de commande 1 et le transistor de puissance 3 de l'étage de puissance 2. En effet, la communication peut alors se produire par l'intermédiaire du lien d'asservissement entre le dispositif de commande 1 et le transistor de puissance 3 de manière à ce que le dispositif de commande 1 exerce une influence sur le transistor de puissance 3. Et, avantageusement, cette communication peut aussi permettre, par l'intermédiaire de la communication entre la commande de puissance et de détection de défaut 21 et le détecteur de dysfonctionnement du circuit primaire 17, d'informer le dispositif de commande 1 de tout état de fonctionnement du transistor de puissance 3, voire même au dispositif de commande 1 d'obtenir un retour des informations de fonctionnement provenant du dispositif de commande 1 même. Plus précisément, la communication entre la commande de puissance et de détection de défaut 21 et le détecteur de dysfonctionnement du circuit primaire 17 se produit par l'intermédiaire du transformateur 30 d'impulsion, ce qui présente l'avantage de limiter le nombre de composant nécessaire à cette communication entre circuit primaire 10 et circuit secondaire 20.

Avantageusement, le module de commande 12 comprend :
- un oscillateur 14 apte à générer une onde impulsive prédéfinie Pulse en fonction d'un signal commande Sc provenant de l'extérieur de l'étage de puissance 2. Plus précisément, l'oscillateur 14 est apte à générer l'onde impulsive Pulse de manière répétitive selon une fréquence supérieure à 100 kilohertz. De plus, de manière préférentielle, l'onde impulsive Pulse peut être répétée selon une fréquence d'environ 500 kilohertz, soit avec une période de 2 *µs.* Ainsi, lorsque le module de commande 12 reçoit un signal de commande extérieur d'activation *Scₒₙ* extérieur à l'étage de puissance 2, l'oscillateur 14 génère, en accord avec le signal de commande extérieur d'activation *Scₒₙ*, une onde impulsive d'activation Pulse1. A l'inverse, lorsque le module de commande 12 reçoit un signal de commande extérieur d'arrêt *Sc_{off}* extérieur à l'étage de puissance 2, l'oscillateur 14 génère, en accord avec ce signal de commande d'arrêt *Sc_{off},* une onde impulsive d'arrêt Pulse2. A titre d'exemple indicatif, l'onde impulsive d'activation Pulse1 peut être une impulsion en créneaux, dont un temps d'émission de l'impulsion haute s'étend pendant 200 nanosecondes et dont un temps d'émission de l'impulsion basse s'étend pendant 1,8 microseconde. De manière similaire, l'onde impulsive d'arrêt Pulse2 peut être une impulsion en créneaux, dont le temps d'émission de l'impulsion haute s'étend pendant 1,8 microseconde et dont le temps d'émission de l'impulsion basse s'étend pendant 200 nanosecondes. Néanmoins, à titre indicatif, le temps d'émission de l'impulsion haute et de l'impulsion basse de l'onde impulsive Pulse peut être compris entre 20 microsecondes et 10 nanosecondes. De plus, lorsque le signal commande Sc extérieur est modifié, en passant d'un signal de commande extérieur d'activation *Scₒₙ* à un signal de commande extérieur d'arrêt *Sc_{off}* par exemple ou encore en passant d'un signal de commande extérieur d'arrêt *Sc_{off}* à un signal de commande extérieur d'activation *Scₒₙ*, l'oscillateur 14 est réinitialisé afin de générer l'onde impulsive Pulse en accord avec la modification du signal commande Sc extérieur.

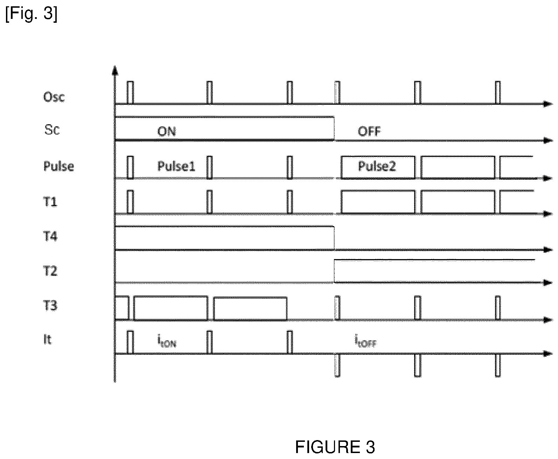

- un pont complet 16, connecté à l'oscillateur 14, apte à générer le courant de commande *iₜ* en fonction de l'onde impulsive prédéfinie Pulse en direction de du transformateur 30 d'impulsion. Le pont complet 16 comprend classiquement, comme représenté en figure 2, un premier transistor T1 et un troisième transistor T3 reliés, par l'intermédiaire de l'enroulement primaire 32, à un deuxième transistor T2 et à un quatrième transistor T4. Le premier transistor T1 ainsi que le troisième transistor T3 forment ainsi un premier demi pont mis en parallèle d'un second demi pont représenté par le deuxième transistor T2 et par le quatrième transistor T4. Ainsi, lorsque l'oscillateur 14 transmet une onde impulsive d'activation Pulse1, comme représenté en figure 3, le pont complet 16 génère un courant de commande d'activation *iₜₒₙ* aux bornes de l'enroulement primaire 32 en direction du transformateur 30. Et, de façon similaire, lorsque l'oscillateur 14 transmet une onde impulsive d'arrêt Pulse2, le pont complet 16 génère un courant de commande d'arrêt *i_{toff}* aux bornes de l'enroulement primaire 32 en direction du transformateur 30. Ainsi, le courant de commande it, comprend des impulsions représentatives de sorte à être une image électrique du signal commande extérieur Sc par la connaissance de l'onde impulsive Pulse.

Il est à noter que le courant de commande d'activation *iₜₒₙ* traversant l'enroulement primaire 32 peut être un courant d'impulsions positives répétées et que le courant de commande d'arrêt *i_{toff}* traversant l'enroulement primaire 32 peut être un courant d'impulsions négatives répétées, comme représenté en figure 3, ou inversement. La génération du courant de commande d'activation *iₜₒₙ* et/ou du courant de commande d'arrêt *i_{toff}* est cyclique et est avantageusement synchrone par rapport au signal commande extérieur Sc et à l'onde impulsive Pulse. C'est-à-dire que, lors d'un passage d'un courant de commande d'arrêt *i_{toff}* à un courant de commande d'activation *iₜₒₙ*, ou inversement, la génération cyclique du nouveau courant, à savoir le courant de commande d'activation *iₜₒₙ*, est régénérée, par l'intermédiaire d'une réinitialisation de l'oscillateur 14, de manière à ne pas avoir de retard entre la nouvelle commande induite par le nouveau courant de commande et la mise en place du transistor de puissance 3, en réponse à cette nouvelle commande, à savoir son activation.

A titre d'exemple indicatif, le retard entre la nouvelle commande induite par le nouveau courant de commande et la mise en place du transistor de puissance 3 en réponse à cette nouvelle commande est inférieur à cent nanosecondes.

Le pont complet 16 est donc configuré pour générer de manière synchronisée le courant de commande *iₜ* en fonction du signal de commande extérieur Sc et/ou de l'onde impulsive prédéfinie Pulse en direction de du transformateur 30 d'impulsion. C'est-à-dire que le pont complet 16 est apte à générer de manière synchronisée un train d'impulsions positives ou courant de commande d'activation *iₜₒₙ* en réception d'un signal de commande extérieur d'activation *Scₒₙ* et/ou d'une onde impulsive d'activation Pulse1 et un train d'impulsions négatives ou courant de commande d'arrêt *i_{toff}* en reception d'un signal de commande extérieur d'arrêt *Sc_{off}* et/ou d'une onde impulsive d'arrêt Pulse2.

Cette configuration de mise en série de l'oscillateur 14 et du pont complet 16 présente l'avantage de permettre de transformer une commande continue, en signal alternatif pouvant être transmis par le transformateur 30. Par exemple, le transistor de puissance 3 peut être un interrupteur de puissance. La commande Sc est un signal binaire où le niveau haut correspond à la fermeture de l'interrupteur et le niveau bas correspond à l'ouverture de l'interrupteur. La présence de l'oscillateur 14 et du pont complet 16 transforme le niveau haut du signal de commande extérieur Sc, traduisant une commande d'activation par exemple, en un train d'impulsions positives *iₜₒₙ*. A l'inverse, le niveau bas du signal de commande extérieur Sc, traduisant par exemple une commande d'arrêt, est transformé en un train d'impulsions négatives *i_{toff}.*

La commande de puissance et de détection de défaut 21 comprend une impédance R connectée entre les bornes électriques de l'enroulement secondaire 34 du transformateur 30 d'impulsion. L'impédance R comprend une résistance électrique inférieure à 200 ohms. L'impédance comprend une résistance électrique inférieur à un kilo ohms et supérieur à cinquante ohms. Cette configuration de boucle fermée entre l'enroulement secondaire 34 et l'impédance R présente l'avantage de limiter la susceptibilité magnétique du dispositif de commande 1 et de l'immuniser de toute perturbation électromagnétique extérieure à l'étage de puissance 2 en assurant une circulation d'un courant électrique important dans cette boucle fermée. En d'autres termes, la liaison entre le transformateur 30 et l'impédance R forme une ligne à basse impédance. A titre d'exemple préférentiel, l'impédance R comprend une résistance électrique de 200 ohms.

Comme énoncé précédemment, le détecteur de dysfonctionnement du circuit primaire 17 est apte à détecter un dysfonctionnement dans le circuit primaire 10, c'est-à-dire un défaut quelconque induisant à un fonctionnement non nominal dans le circuit primaire 10 et particulièrement dans le pont complet 16. Plus précisément, le détecteur de dysfonctionnement du circuit primaire 17 comprend un détecteur de court-circuit 18, apte à détecter un surcourant circulant dans le circuit primaire 10. Par exemple, le détecteur de court-circuit 18 est apte à détecter un défaut d'ouverture dans le circuit primaire 10 c'est-à-dire une ouverture du circuit électrique du circuit primaire 10 ou ouverture de la ligne de commande délivrant le signal de commande Sc et/ou un défaut de court-circuit dans le circuit primaire 10 et/ou dans le pont complet 16, c'est-à-dire un court-circuit dans le circuit primaire ou un court-circuit dans le pont complet 16.

La détection d'un défaut d'ouverture ou d'un défaut de court-circuit permet ainsi d'augmenter la précision de la détection et de connaitre précisément l'origine du dysfonctionnement dans le circuit primaire 10.

En effet, un défaut d'ouverture ou un défaut de court-circuit dans le circuit primaire 10 induit à une augmentation significative du courant de commande *iₜ* et donc à un surcourant au niveau du détecteur de dysfonctionnement du circuit primaire 17 et du détecteur de court-circuit 18. A titre d'exemple, dès lors où le détecteur de court-circuit 18 détecte un courant supérieur à 100 milliampères, le détecteur de court-circuit 18 indique la présence d'un surcourant et permet au détecteur de dysfonctionnement du circuit primaire 17 d'alerter quant à la présence d'un dysfonctionnement du circuit primaire 10 et d'un défaut de fonctionnement global du dispositif de commande 1 de l'étage de puissance 2.

Le détecteur de dysfonctionnement du circuit primaire 17 peut également comprendre un enregistreur 19 apte à enregistrer le dysfonctionnement du circuit primaire 10. L'enregistreur 19 est connecté au détecteur de court-circuit 18 de manière à enregistrer le défaut d'ouverture et/ou le défaut de court-circuit afin d'enregistrer précisément la cause induisant le dysfonctionnement du circuit primaire 10. L'enregistreur 19 est également apte à enregistrer le dysfonctionnement du circuit secondaire 20 et/ou du transistor de puissance 3.

L'enregistreur 19 permet ainsi l'enregistrement de tous les précédents dysfonctionnements et blocages de la transmission d'une commande afin d'éviter de potentiels autres dysfonctionnements.

Avantageusement, la commande de puissance et de détection de défaut 21 comprend :
∘ Un détecteur d'impulsion 22 apte à détecter un défaut d'impulsion dans le courant impulsionnel induit *iₘ* . Plus précisément, le détecteur d'impulsion 22 peut détecter une absence d'impulsion dans le courant impulsionnel induit *iₘ* , reflétant une absence de commande transcrite par le transformateur 30, ou encore par le pont complet 16, en amont de la commande de puissance et de détection de défaut 21. Ainsi, lorsque le détecteur impulsionnel 22 détecte une absence d'impulsion dans le courant impulsionnel induit *iₘ* , la commande de puissance et de détection de défaut 21 peut informer de la présence d'un dysfonctionnement global du dispositif de commande 1 de l'étage de puissance 2. De manière similaire, le détecteur d'impulsion 22 est apte à détecter une irrégularité des impulsions du courant impulsionnel induit *iₘ*, c'est-à-dire des fréquences d'impulsions irrégulières par exemple. Ainsi, un défaut d'impulsion peut être interprété comme une absence d'impulsions détectées ou une détection d'impulsions irrégulières dans le courant impulsionnel induit *iₘ*. Le détecteur d'impulsion 22 présente l'avantage de permettre un ciblage précis du dysfonctionnement du circuit secondaire 20, à savoir par exemple un défaut de transmission de l'information par le transformateur 30 d'impulsion par exemple. En outre, le détecteur d'impulsion 22 est apte à redresser le courant impulsionnel induit *iₘ*, qui est un courant alternatif suite à son induction dans le deuxième enroulement 34 du transformateur 30 d'impulsion. Ce redressement présente l'avantage de convertir le courant impulsionnel induit *iₘ* d'un courant alternatif vers un courant continu facilitant alors la détection des impulsions dans le courant impulsionnel induit *iₘ*.
∘ Un détecteur de fonctionnement 24 du transistor de puissance 3, apte à détecter un défaut de fonctionnement du transistor de puissance 3. Plus précisément, le détecteur de fonctionnement 24 est relié directement au transistor de puissance 3 de sorte à pouvoir détecter au moins un paramètre du transistor de puissance 3 induisant un fonctionnement non nominal du transistor de puissance 3, comme par exemple une saturation anormale du transistor de puissance 3. Le détecteur de fonctionnement 24 présente l'avantage de permettre un ciblage précis du dysfonctionnement du module électronique 3.

De plus, la commande de puissance et de détection de défaut 21 comprend un élément d'arrêt 26 relié au détecteur d'impulsion 22 et au détecteur de fonctionnement 24 du transistor de puissance 3 apte à court-circuiter l'enroulement secondaire 34 du transformateur 30 en fonction d'une anomalie détectée par la commande de puissance et de détection de défaut 21. Plus particulièrement, en cas de défaut d'impulsion dans le courant impulsionnel induit *iₘ* détecté par le détecteur d'impulsion 22 et/ou en cas de défaut de fonctionnement du transistor de puissance 3 détecté par le détecteur de fonctionnement 24, l'élément d'arrêt 26 peut court-circuiter l'enroulement secondaire 34 du transformateur 30 d'impulsion. A titre d'exemple, l'élément d'arrêt 26 peut être un interrupteur raccordé en parallèle de l'enroulement secondaire 34 et piloté par la commande de puissance et de détection de défaut 21.

Or, lorsqu'un court-circuit est opéré au niveau du circuit secondaire 20, un surcourant se forme alors au niveau du circuit primaire 10. Et, comme présenté précédemment, ce surcourant est directement détecté par le détecteur de court-circuit 18 détecteur de dysfonctionnement du circuit primaire 17 permettant d'alerter d'un défaut de fonctionnement du dispositif de commande 1. De cette manière, la commande de puissance et de détection de défaut 21 est apte à communiquer le dysfonctionnement du circuit secondaire 20 au détecteur de dysfonctionnement du circuit primaire 17 et permet également d'enregistrer le dysfonctionnement du circuit secondaire 20 et/ou du transistor de puissance 3 détecté par la commande de puissance et de détection de défaut 21 ainsi que la cause de ce dysfonctionnement par l'intermédiaire de l'enregistreur 19. Ainsi, l'enregistreur 19 apte à enregistrer le dysfonctionnement du circuit primaire 10 et le dysfonctionnement du circuit secondaire 20.

Ainsi, une alerte du détecteur de court-circuit 18 couplée à une alerte du détecteur de fonctionnement 24 permet, à titre d'exemple indicatif, de mettre en lumière un fonctionnement anormal du transistor de puissance 3. Une alerte du détecteur de court-circuit 18 couplée à une alerte liée à un défaut d'impulsion dans le courant impulsionnel induit *iₘ* par le détecteur impulsionnel 22 permet, à titre d'exemple indicatif, de mettre en lumière un fonctionnement anomal du dispositif de commande 1. Et, une alerte du détecteur de court-circuit 18 permet, à titre indicatif, de mettre en lumière un défaut électrique au niveau du circuit primaire 10 et particulièrement du pont complet 16.

La commande de puissance et de détection de défaut 21 est connecté à un pilote 28 du transistor de puissance 3 apte à générer une commande du transistor de puissance 3 à partir du courant impulsionnel induit *iₘ*. Plus précisément, le pilote 28 est électriquement connecté aux bornes électriques de l'enroulement secondaire 34, le pilote 28 est également relié au détecteur impulsionnel 22 de manière à générer un lien d'asservissement du pilote 28 par le détecteur impulsionnel 22 et au transistor de puissance 3. Ainsi, le pilote 28 est apte à extraire les impulsions du courant impulsionnel induit *iₘ* et à générer une commande du transistor de puissance 3. La communication entre le pilote 28 et le transistor de puissance 3 est quelconque et peut être, à titre d'exemple non exhaustif, électrique ou optique. De manière préférentielle, la communication entre le pilote 28 et le transistor de puissance 3 est électrique comme la communication entre le transistor de puissance 3 et le détecteur de fonctionnement 24. Néanmoins, dans le cas d'une différence de potentiel électrique entre le pilote 28 et le transistor de puissance 3, une isolation des deux composants est nécessaire. Dès lors, la communication entre le pilote 28 et le transistor de puissance peut être optique comme la communication entre le transistor de puissance 3 et le détecteur de fonctionnement 24.

Le pilote 28 de l'étage de puissance permet de reconstituer, en phase, c'est-à-dire avec un retard inférieur à 100 nanosecondes, le signal commande Sc extérieur reçu par le module de commande 12. Le pilote 28 présente ainsi l'avantage d'avoir un pilotage direct du transistor de puissance 3 en fonction de la commande transmise par le dispositif de commande 1.

En outre, le pilote 28 de courant comprend un désactivateur de commande 282 apte à annuler la commande du transistor de puissance 3 générée par le pilote 28. Plus précisément, le désactivateur de commande 282 permet de désactiver le lien de commande entre le dispositif de commande 1 et le transistor de puissance 3 lorsqu'un défaut quelconque ou dysfonctionnement est détecté. Le désactivateur de commande 282 présente ainsi l'avantage de permettre, avec un retard inférieur à 1 microsecondes, la désactivation effective de la commande du dispositif de commande 1 sur le transistor de puissance 3 dès l'annonce d'un dysfonctionnement du dispositif de commande 1 ou du transistor de puissance 3 et donc de ne pas dégrader l'étage de puissance 2 et le transistor de puissance 3.

## Revendications

1. Etage de puissance (2) comprenant un dispositif de commande (1) et un transistor de puissance (3) connecté au dispositif de commande (1) afin d'être piloté par le dispositif de commande (1), le dispositif de commande (1) comprenant :
∘ un circuit primaire (10) comprenant un module de commande (12) apte à générer un courant de commande *iₜ*,
∘ un circuit secondaire (20),
∘ Un transformateur (30) d'impulsion comprenant un enroulement primaire (32) relié au circuit primaire (10), le transformateur (30) d'impulsion comprenant un enroulement secondaire (34) relié au circuit secondaire (20), magnétiquement couplé à l'enroulement primaire (32) et apte à générer, à partir du courant de commande *iₜ*, un courant impulsionnel induit *iₘ* en direction du circuit secondaire (20), le courant impulsionnel induit *iₘ* permettant le pilotage du transistor de puissance (3),
le circuit secondaire (20) comprenant une commande de puissance et de détection de défaut (21), relié à l'enroulement secondaire (34) du transformateur (30) d'impulsion et au transistor de puissance (3), apte à détecter un dysfonctionnement du circuit secondaire (20) et/ou du transistor de puissance (3),
**caractérisé en ce que** le circuit primaire comprend un détecteur de dysfonctionnement du circuit primaire (17) apte à détecter un dysfonctionnement du circuit primaire (10) et comprenant un détecteur de court-circuit (18), le détecteur de court-circuit (18) étant apte à détecter un surcourant dans le circuit primaire (10),
**en ce que** la commande de puissance et de détection de défaut (21) comprend un élément d'arrêt (26) apte à court-circuiter le transformateur (30) d'impulsion en fonction d'une détection de défaut entrainant un surcourant dans le circuit primaire,
**en ce que** la commande de puissance et de détection de défaut (21) est apte à communiquer le dysfonctionnement du circuit secondaire (20) et/ou du transistor de puissance (3) au détecteur de dysfonctionnement du circuit primaire (17),
et **en ce que** le surcourant entrainé dans le circuit primaire est détectable par le détecteur de court-circuit (18).

2. Etage de puissance (2) selon la revendication 1, dans lequel la commande de puissance et de détection de défaut (21) communique le dysfonctionnement du circuit secondaire (20) et/ou du transistor de puissance (3) au détecteur de dysfonctionnement du circuit primaire (17) uniquement par l'intermédiaire du transformateur (30) d'impulsion.

3. Etage de puissance (2) selon l'une des revendications 1 ou 2, dans lequel le module de commande (12) comprend un oscillateur (14) apte à générer une onde impulsive prédéfinie (Pulse) en fonction d'un signal commande (Sc) provenant de l'extérieur de l'étage de puissance (2) et un pont complet (16), connecté à l'oscillateur (14) apte à générer le courant de commande *iₜ* en fonction de l'onde impulsive prédéfinie (Pulse) en direction de l'enroulement primaire (32) du transformateur (30) d'impulsion.

4. Etage de puissance (2) selon la revendication 3, dans lequel le pont complet (16) est configuré pour générer de manière synchronisée le courant de commande *iₜ* en fonction du signal de commande extérieur (Sc) et/ou de l'onde impulsive prédéfinie (Pulse).

5. Etage de puissance (2) selon les revendications 1 à 3, l'enroulement secondaire (20) comprenant deux bornes électriques, la commande de puissance et de détection de défaut (21) comprenant une impédance R connectée aux deux bornes électriques de l'enroulement secondaire (34) du transformateur (30) d'impulsion, l'impédance R comprenant une résistance électrique inférieure à 1000 ohms.

6. Etage de puissance (2) selon la revendication 6, dans lequel le détecteur de court-circuit (18) est apte à détecter un défaut d'ouverture dans le circuit primaire (10) et/ou un défaut de court-circuit dans le circuit primaire (10).

7. Etage de puissance (2) selon l'une des revendications 1 à 6, dans lequel la commande de puissance et de détection de défaut (21) comprend un détecteur d'impulsion (22) apte à détecter un défaut d'impulsion dans le courant impulsionnel induit iₘ.

8. Etage de puissance (2) selon la revendication 8 dans lequel le détecteur d'impulsion (22) est configuré pour redresser le courant impulsionnel induit *iₘ*.

9. Etage de puissance (2) selon l'une des revendications 1 à 8, dans lequel la commande de puissance et de détection de défaut (21) comprend un détecteur de fonctionnement (24) du transistor de puissance (3), apte à détecter au moins un paramètre du transistor de puissance (3) induisant un fonctionnement non nominal du transistor de puissance (3).

10. Etage de puissance (2) selon la revendication 1 à 10, comprenant un pilote (28) du transistor de puissance (3) apte à générer une commande du transistor de puissance (3) à partir du courant impulsionnel induit *iₘ*.

11. Etage de puissance (2) selon la revendication 1 à 11, dans lequel le détecteur de dysfonctionnement du circuit primaire (17) comprend un enregistreur apte à enregistrer le dysfonctionnement du circuit primaire et/ou le dysfonctionnement du circuit secondaire (20) et/ou du transistor de puissance (3).

12. Etage de puissance (2) selon l'une des revendications 1 à 12, dans lequel le pilote (28) de courant comprend un désactivateur de commande (282), configuré pour annuler la commande du transistor de puissance (3) lorsqu'un dysfonctionnement circuit primaire et/ou du circuit secondaire (20) et/ou du transistor de puissance (3) est détecté.

## Patentansprüche

1. Leistungsstufe (2), umfassend eine Steuereinheit (1) und einen Leistungstransistor (3), der mit der Steuereinheit (1) verbunden ist, um von der Steuereinheit (1) gesteuert zu werden, wobei die Steuereinheit (1) umfasst:
- einen primären Schaltkreis (10), umfassend ein Steuerungsmodul (12), das in der Lage ist, einen Steuerstrom *iₜ* zu erzeugen,
- einen sekundären Schaltkreis (20),
- einen Impulstransformator (30), umfassend eine primäre Wicklung (32), die mit dem primären Schaltkreis (10) verbunden ist, wobei der Impulstransformator (30) eine sekundäre Wicklung (34) umfasst, die mit dem sekundären Schaltkreis (20) verbunden, mit der primären Wicklung (32) magnetisch gekoppelt und in der Lage ist, ausgehend von dem Steuerstrom *iₜ* einen induzierten Impulsstrom *iₘ* in Richtung des sekundären Schaltkreises (20) zu erzeugen, wobei der induzierte Impulsstrom *iₘ* ermöglicht, den Leistungstransistor (3) zu steuern,
wobei der sekundäre Schaltkreis (20) eine Leistungs- und Fehlerdetektionssteuerung (21), die mit der sekundären Wicklung (34) des Impulstransformators (30) und mit dem Leistungstransistor (3) verbunden ist, umfasst, die in der Lage ist, eine Fehlfunktion des sekundären Schaltkreises (20) und/oder des Leistungstransistors (3) zu detektieren,
**dadurch gekennzeichnet, dass** der primäre Schaltkreis einen Fehlfunktionsdetektor (17) des primären Schaltkreises umfasst, der in der Lage ist, eine Fehlfunktion des primären Schaltkreises (10) zu detektieren, und einen Kurzschlussdetektor (18) umfasst, wobei der Kurzschlussdetektor (18) in der Lage ist, einen Überstrom in dem primären Schaltkreis (10) zu detektieren,
und dadurch, dass die Leistungs- und Fehlerdetektionssteuerung (21) ein Sperrelement (26) umfasst, das in der Lage ist, den Impulstransformator (30) abhängig von einer Detektion eines Fehlers, der in dem primären Schaltkreis einen Überstrom verursacht, kurzzuschließen,
und dadurch, dass die Leistungs- und Fehlerdetektionssteuerung (21) in der Lage ist, die Fehlfunktion des sekundären Schaltkreises (20) und/oder des Leistungstransistors (3) an den Fehlfunktionsdetektor des primären Schaltkreises (17) zu kommunizieren,
und dadurch, dass der in dem primären Schaltkreis verursachte Überstrom durch den Kurzschlussdetektor (18) detektierbar ist.

2. Leistungsstufe (2) nach Anspruch 1, wobei die Leistungs- und Fehlerdetektionssteuerung (21) die Fehlfunktion des sekundären Schaltkreises (20) und/oder des Leistungstransistors (3) einzig mittels des Impulstransformators (30) an den Fehlfunktionsdetektor (17) des primären Schaltkreises kommuniziert.

3. Leistungsstufe (2) nach einem der Ansprüche 1 oder 2, wobei das Steuerungsmodul (12) einen Oszillator (14), der in der Lage ist, abhängig von einem Steuersignal (Sc), das von der Außenseite der Leistungsstufe (2) stammt, eine vordefinierte Impulswelle (Puls) zu erzeugen, und eine Vollbrücke (16) umfasst, die mit dem Oszillator (14) verbunden ist, der in der Lage ist, abhängig von der vordefinierten Impulswelle (Puls) den Steuerstrom *iₜ* in Richtung der primären Wicklung (32) des Impulstransformators (30) zu erzeugen.

4. Leistungsstufe (2) nach Anspruch 3, wobei die Vollbrücke (16) konfiguriert ist zum Erzeugen des Steuerstroms *iₜ* auf synchronisierte Weise, abhängig von dem äußeren Steuersignal (Sc) und/oder der vordefinierten Impulswelle (Puls).

5. Leistungsstufe (2) nach einem der Ansprüche 1 bis 3, wobei die sekundäre Wicklung (20) zwei elektrische Anschlüsse umfasst, wobei die Leistungs- und Fehlerdetektionssteuerung (21) eine Impedanz R umfasst, die an den zwei elektrischen Anschlüssen der sekundären Wicklung (34) des Impulstransformators (30) angeschlossen ist, wobei die Impedanz R einen elektrischen Widerstand weniger als 1000 Ohm umfasst.

6. Leistungsstufe (2) nach Anspruch 6, wobei der Kurzschlussdetektor (18) in der Lage ist, einen Öffnungsfehler in dem primären Schaltkreis (10) und/oder einen Kurzschlussfehler in dem primären Schaltkreis (10) zu detektieren.

7. Leistungsstufe (2) nach einem der Ansprüche 1 bis 6, wobei die Leistungs- und Fehlerdetektionssteuerung (21) einen Impulsdetektor (22) umfasst, der in der Lage ist, einen Impulsfehler in dem induzierten Impulsstrom iₘ zu detektieren.

8. Leistungsstufe (2) nach Anspruch 8, wobei der Impulsdetektor (22) konfiguriert ist zum Gleichrichten des induzierten Impulsstroms *iₘ*.

9. Leistungsstufe (2) nach einem der Ansprüche 1 bis 8, wobei die Leistungs- und Fehlerdetektionssteuerung (21) einen Detektor (24) der Funktionsweise des Leistungstransistors (3) umfasst, der in der Lage ist, mindestens einen Parameter des Leistungsdetektors (3) zu detektieren, der eine nicht nominale Funktionsweise des Leistungstransistors (3) induziert.

10. Leistungsstufe (2) nach Anspruch 1 bis 10, umfassend einen Treiber (28) des Leistungstransistors (3), der in der Lage ist, ausgehend von dem induzierten Impulsstrom *iₘ* eine Steuerung des Leistungstransistors (3) zu erzeugen.

11. Leistungsstufe (2) nach Anspruch 1 bis 11, wobei der Fehlfunktionsdetektor des primären Schaltkreises (17) ein Aufzeichnungsgerät umfasst, das in der Lage ist, die Fehlfunktion des primären Schaltkreises und/oder die Fehlfunktion des sekundären Schaltkreises (20) und/oder des Leistungstransistors (3) aufzuzeichnen.

12. Leistungsstufe (2) nach einem der Ansprüche 1 bis 12, wobei der Treiber (28) des Stroms einen Steuerungsdeaktivator (282) umfasst, der zum Annulieren der Leistungstransistorsteuerung (3) konfiguriert ist, wenn eine Fehlfunktion des primären Schaltkreises und/oder des sekundären Schaltkreises (20) und/oder des Leistungstransistors (3) detektiert wird.

## Claims

1. Power stage (2) comprising a control device (1) and a power transistor (3) connected to the control device (1), in order to be controlled by the control device (1), the control device (1) comprising:
- a primary circuit (10) comprising control module (12) capable of generating a control current *iₜ*,
- a secondary circuit (20),
- a pulse transformer (30) comprising a primary winding (32) connected to the primary circuit (10), the pulse transformer (30) comprising a secondary winding (34) connected to the secondary circuit (20), magnetically coupled to the primary winding (32) and capable of generating, from the control current *iₜ*, an induced pulse current *iₘ* in the direction of the secondary circuit (20), the induced pulse current *iₘ* enabling the control of the power transistor (3),
the secondary circuit (20) comprising a power and fault detection control (21), connected to the secondary winding (34) of the pulse transformer (30) and to the power transistor (3), capable of detecting a malfunction of the secondary circuit (20) and/or of the power transistor (3),
**characterized in that** the primary circuit comprises a malfunction detector of the primary circuit (17) capable of detecting a malfunction of the primary circuit (10) and comprising a short-circuit detector (18), the short-circuit detector (18) being capable of detecting an overcurrent in the primary circuit (10),
**in that** the power and fault detection control (21) comprises a stop element (26) capable of short-circuiting the pulse transformer (30) according to a fault detection leading to an overcurrent in the primary circuit,
**in that** the power and fault detection control (21) is capable of communicating the malfunction of the secondary circuit (20) and/or of the power transistor (3) to the malfunction detector of the primary circuit (17),
and **in that** the overcurrent driven in the primary circuit is detectable by the short-circuit detector (18).

2. Power stage (2) according to claim 1, wherein the power and fault detection control (21) communicates the malfunction of the secondary circuit (20) and/or of the power transistor (3) to the malfunction detector of the primary circuit (17) only through the pulse transformer (30).

3. Power stage (2) according to any one of claims 1 or 2, wherein the control module (12) comprises an oscillator (14) capable of generating a predefined pulse wave (Pulse) according to a control signal (Sc) coming from the outside of the power stage (2) and a complete bridge (16), connected to the oscillator (14) capable of generating the control current *iₜ* according to the predefined pulse wave (Pulse) in the direction of the primary winding (32) of the pulse transformer (30).

4. Power stage (2) according to claim 3, wherein the complete bridge (16) is configured to generate, in a synchronised manner, the control current *iₜ* according to the outer control signal (Sc) and/or to the predefined pulse wave (Pulse).

5. Power stage (2) according to claims 1 to 3, the secondary winding (20) comprising two electric terminals, the power and fault detection control (21) comprising an impedance R connected to the two electric terminals of the secondary winding (34) of the pulse transformer (30), the impedance R comprising an electric resistance less than 1000 ohms.

6. Power stage (2) according to claim 6, wherein the short-circuit detector (18) is capable of detecting an opening fault in the primary circuit (10) and/or a short-circuit fault in the primary circuit (10).

7. Power stage (2) according to any one of claims 1 to 6, wherein the power and fault detection control (21) comprises a pulse detector (22) capable of detecting a pulse fault in the induced pulse current iₘ.

8. Power stage (2) according to claim 8, wherein the pulse detector (22) is configured to redress the induced pulse current iₘ.

9. Power stage (2) according to any one of claims 1 to 8, wherein the power and fault detection control (21) comprises an operating detector (24) of the power transistor (3), capable of detecting at least one parameter of the power transistor (3) inducing a non-nominal operation of the power transistor (3).

10. Power stage (2) according to claims 1 to 10, comprising a driver (28) of the power transistor (3) capable of generating a control of the power transistor (3) from the induced pulse current *iₘ*.

11. Power stage (2) according to claims 1 to 11, wherein the malfunction detector of the primary circuit (17) comprises a recorder capable of recording the malfunction of the primary circuit and/or the malfunction of the secondary circuit (20) and/or of the power transistor (3).

12. Power stage (2) according to any one of claims 1 to 12, wherein the current driver (28) comprises a control deactivator (282), configured to cancel the control of the power transistor (3) when a malfunction of the primary circuit and/or of the secondary circuit (20) and/or of the power transistor (3) is detected.
